# EUROPÄISCHE PATENTSCHRIFT

(11) **EP 1 874 106 B1**
(45) Veröffentlichungstag und Bekanntmachung des Hinweises auf die Patenterteilung: **20.04.2011**
(21) Anmeldenummer: 07111068.8
(22) Anmeldetag: 26.06.2007
(51) Int. Cl.: H05K 13/04

(54) **Zuführeinrichtung zur Zufuhr von Bauelementen zu einem Bestückautomaten**
Feeder device for feeding components into a charging device
Dispositif d'alimentation pour l'introduction de composants dans un automate d'implantation

(30) Priorität: 28.06.2006 DE 102006029712
(43) Veröffentlichungstag der Anmeldung: 02.01.2008
(73) Patentinhaber: ASM Assembly Systems GmbH & Co. KG, 81379 München (DE)
(72) Erfinder: Drobner, Franz, 85570, Ottenhofen (DE); Fischer, Jakob, 81479, München (DE); Pajonk, Joachim, 83714, Miesbach (DE)
(74) Vertreter: Kuhlmann, Kai

(56) Entgegenhaltungen:
- WO-A-2006/011563
- WO-A-2007/048445

## Beschreibung

Die vorliegende Erfindung betrifft eine Zuführeinrichtung zur Zufuhr von Bauelementen zu einem Bestückautomaten zum Bestücken von Substraten mit den Bauelementen, umfassend eine Halterung für eine im Wesentlichen ebene Anordnung von Bauelementen, eine drehbar gelagerte Überführungseinrichtung zur Überführung von Bauelementen von der Anordnung von Bauelementen zu einem Bestückkopf des Bestückautomaten, und eine Kamera mit einem zugeordneten optischen Strahlengang zur Aufnahme von Bildern der Anordnung von Bauelementen.

Derartige Zuführeinrichtungen sind aus dem Stand der Technik bekannt. So offenbart beispielsweise die US-Veröffentlichungsschrift US 2004/0163243 A1 einen so genannten "Wafer Feeder", zur Zufuhr von Halbleiterchips von einem Halbleiter-Wafer zu einem Bestückkopf eines Bestückautomaten. Dabei wird ein drehbar gelagerter Übertragungskopf offenbart, welcher in einem mehrstufigen Ablauf einen Chip vom Wafer zum Bestückkopf übergibt. Dieser Übergabevorgang findet in drei Schritten statt: Zuerst findet eine Überprüfung statt, ob überhaupt ein Bauelement am Kopf befindlich ist, dann wird zweitens mit einer Kamera die Position des Bauelements an der Überführungseinrichtung bestimmt und dann erfolgt drittens der Transport des Bauelements in die Position, an welcher der Bestückkopf es abholen kann. Weiterhin umfasst die Zuführeinrichtung zwei Kameras: eine erste Kamera zur Betrachtung des Wafers und eine zweite Kamera zur Betrachtung des Chips am Bestückkopf.

Weiterhin ist die Deutsche Patentschrift DE 10 2004 007 703 B3 bekannt, welche ebenfalls einen so genannten Wafer Feeder offenbart. Auch dieser weist einen drehbar gelagerten Übertragungskopf auf, mittels welchem Bauelemente vom Halbleiter-Wafer zum Bestückkopf eines Bestückautomaten übergeben werden können. Weiterhin ist eine Kamera zur Betrachtung des Halbleiter-Wafers vorgesehen, mit welcher allerdings nur dann Bilder vom Wafer aufgenommen werden können, wenn sich der Bestückkopf von der Übernahmeposition weg bewegt hat und der Übertragungskopf in einer ganz bestimmten räumlichen Stellung steht.

Die Veröffentlichungsschrift WO 2006/011563 A1 offenbart einen sogenannten "Flip-Chip-Bonder" zur Montage von Halbleiterbauelementen auf einer Leiterplatte. Dabei wird ein sogenannter "Flipkopf" offenbart, mit welchem die Bauelemente vom Wafer abgenommen und gewendet werden. Ein Bestückkopf übernimmt dann dieses Bauelement und platziert es auf der Leiterplatte. Oberhalb des Flipkopfs ist weiterhin eine Kamera zur Betrachtung des Wafers in diesem Dokument offenbart.

Zudem offenbart die Veröffentlichungsschrift WO 2007/048445 A1, welche gemäß Artikel 54 (3) EPÜ i.V.m Regel 165 EPÜ zum Stand der Technik zählt, eine Bestückvorrichtung für Halbleiterbauelemente mit einer zusätzlichen Wendevorrichtung zum seitenrichtigen Plazieren des Halbleiterbauelements. Dabei ist ebenfalls eine Kamera vorgesehen, mit welcher die Abnahmestelle des Bauelements betrachtet wird.

Der genannte Stand der Technik weist insbesondere dann Nachteile auf, wenn ein Bestückautomat mit einem so genannten Mehrfach-Bestückkopf verwendet wird. Dabei befinden sich mehrere Aufnahmeelemente für die Bauelemente, die beispielsweise als Vakuum-Pipetten ausgebildet sein können, an einem Bestückkopf. Der Bestückkopf kann z.B. drehbar als so genannter "Revolverkopf" oder auch als so genannter "Matrixkopf" ausgebildet sein. Bei solchen Mehrfach-Bestückköpfen werden vorteilhafter Weise vor einem Bestückvorgang möglichst viele der Pipetten mit einem zu bestückenden Chip versehen, um einen effizienten Bestückvorgang zu erzielen. Daher bleibt der Bestückkopf bei der Aufnahme der Chips über mehrere Aufnahmevorgänge im Wesentlichen in der gleichen Position. In dieser Position wird im Wesentlichen immer nur eine neue Pipette zur Verfügung gestellt. Vor jeder Aufnahme eines Chips vom Wafer muss im Allgemeinen ein Bild des Wafers aufgenommen werden, um die Lage des aufzunehmenden Chips zu ermittelt und die Pipetten-Position und/oder die Wafer-Position gegebenenfalls entsprechend zu korrigieren. Insbesondere bei der genannten Anwendung ist der Stand der Technik unvorteilhaft, da entweder der Bestückkopf zur Aufnahme eines solchen Bildes komplett verfahren werden muss, was unnötig Zeit kostet, oder die Übertragung vom Wafer zum Bestückkopf über mindestens zwei Stoppstellen ausgebildet ist, was die Geschwindigkeit, mit welchem ein Mehrfach-Bestückkopf beladen werden kann, erheblich einschränkt.

Daher ist es Aufgabe der vorliegenden Erfindung, eine Zuführeinrichtung zur Zufuhr von Bauelementen zu einem Bestückautomaten zur Verfügung zu stellen, welcher besser an Mehrfach-Bestückköpfe bei den Bestückautomaten angepasst ist.

Diese Aufgabe wird gelöst von einer Zuführeinrichtung zur Zufuhr von Bauelementen zu einem Bestückautomaten zum Bestücken von Substraten mit den Bauelementen, umfassend:
Eine Halterung für eine im Wesentlichen ebene Anordnung von Bauelementen,
eine um eine Drehachse drehbare gelagerte Überführungseinrichtung zur Überführung von Bauelementen von der Anordnung von Bauelementen zu einem Bestückkopf des Bestückautomaten, wobei die Überführungseinrichtung mindestens zwei Halteelemente aufweist, die derart ausgebildet und angebracht sind, dass gleichzeitig 1.) ein in einer Aufnahmeposition befindliches erstes der Halteelemente ein erstes Bauelement aus der Anordnung von Bauelementen aufnehmen und 2.) ein in einer Übergabeposition befindliches zweites der Halteelemente ein zweites Bauelement an den Bestückkopf des Bestückautomaten übergeben kann, und
eine Kamera mit einem zugeordneten optischen Strahlengang zur Aufnahme von Bildern der Anordnung von Bauelementen im Bereich der Aufnahmeposition, wobei beim Betrieb der Überführungseinrichtung der optische Strahlengang von Teilen der Überführungseinrichtung höchstens dann gekreuzt wird, wenn sich ein Halteelement im Bereich der Aufnahmeposition befindet.

Dadurch, dass die Zuführeinrichtung derart ausgebildet ist, dass gleichzeitig ein Bauelement an den Bestückkopf übergeben und von der Anordnung von Bauelementen übernommen werden kann, wird erreicht, dass die Zahl der nötigen Stopps bei der Bewegung der Überführungseinrichtung reduziert wird, da sowohl bei der Aufnahme als auch bei der Übergabe eines Bauelements eine Bewegung der Überführungseinrichtung im allgemeinen angehalten wird. Damit lässt sich eine schnellere Übergabe von Bauelementen von der Anordnung von Bauelementen an den Bestückkopf erreichen. Weiterhin wird durch die genannte Anordnung des optischen Strahlengangs erreicht, dass der Blick auf die Anordnung von Bauelementen so wenig wie möglich beeinträchtigt wird und daher eine Behinderung des Übertragungsvorgangs von Bauelementen zum Bestückkopf durch die notwendige Aufnahme von Bildern der Anordnung von Bauelementen reduziert wird.

Die Kombination der gleichzeitigen Aufnahme und Übergabe von Bauelementen mit wie dargestellt optimiertem Strahlengang bildet einen besonderen Vorteil. Durch diese Kombination wird ein besonderer Geschwindigkeitsvorteil speziell beim Übergeben von Bauelementen von einer im Wesentlichen ebenen Anordnung von Bauelementen an einen Mehrfach-Bestückkopf eines Bestückautomaten erreicht, da die Zahl der möglichen StoppPhasen bzw. Unterbrechungen durch das Aufnehmen bzw. Abgeben der Bauelemente und die Aufnahme eines Bildes dabei besonders effizient verringert werden.

Bauelemente können beispielsweise jegliche Art von gehäusten oder ungehäusten elektrischen, elektronischen und/oder optoelektronischen Bauelementen sein, wie z.B. integrierte Schaltkreise, Leuchtdioden, Einzelbauelemente oder Halbleiterlaser. Substrat, auf welchen die Bauelemente bestückt werden, können z.B. Leiterplatten, wie beispielsweise so genannte "Printed Circuit Boards" (PCB) oder beispielsweise auch Metallstrukturen zur elektrischen Kontaktierung von Bauelementen (z.B. so genannte "Lead Frames") sein.

Eine im Wesentlichen ebene Anordnung von Bauelementen kann jede Art von in einer Ebene angeordneten Bauelementen sein (z.B. in einer 1-dimensionalen Reihe oder einer 2-dimensionalen Fläche). Diese können beispielsweise lose auf einem Träger aufliegen oder auch mehr oder weniger fest an einem Träger fixiert sein. So kann eine im Wesentlichen ebene Anordnung von Bauelementen beispielsweise ein gesägter Halbleiter-Wafer auf einer Trägerfolie sein, wobei die Trägerfolie mit einem Klebstoff versehen ist. Weiterhin kann die im Wesentlichen ebene Anordnung von Bauelementen auch zusammenhängende Bauelemente aufweisen, wobei Sollbruchstellen derart vorgesehen sein können, dass einzelne der Bauelemente aus der Anordnung unter Aufbrechen der Sollbruchstellen entfernt werden können. Die Halterung für die im Wesentlichen ebene Anordnung von Bauelementen kann so eingerichtet sein, dass die Anordnung von Bauelementen gegenüber der Überführungseinrichtung genügend stabil fixiert ist. Weiterhin kann die Halterung mit einem Antrieb versehen sein, mittels welchem sich die Halterung mitsamt der Anordnung von Bauelementen bewegen, z.B. verschieben und/oder drehen lässt.

Die Überführungseinrichtung kann insgesamt innerhalb der Zuführeinrichtung unter anderem um eine Drehachse als auch ausschließlich nur um eine Drehachse drehbar gelagert sein. Unabhängig von der Drehung der Überführungseinrichtung als Ganzes können einzelne Teile der Überführungseinrichtung, beispielsweise einzelne oder alle der Halteelemente beweglich in Bezug auf die Überführungseinrichtung gelagert sein, beispielsweise drehbar oder verschiebbar.

Halteelemente können jede Art von Elementen sein, die zum zumindest temporären Fixieren eines Bauelements geeignet und ausgebildet sind. Dazu gehören beispielsweise Pipetten zum Ansaugen von Bauelementen vermittels Unterdruck oder ein Greifer zum Festklemmen oder Festhalten eines Bauelements. Wie vorstehend erwähnt, können solche Halteelemente innerhalb der Überführungseinrichtung drehbar oder verschiebbar gelagert sein. Dabei kann beispielsweise vermittels einer Drehung eines Halteelements die Orientierung eines am Halteelement fixierten Bauelements verändert werden, während vermittels einer Verschiebung beispielsweise ein Bauelement durch das Halteelement aufgenommen werden und/oder wieder abgegeben werden kann.

Unter der Aufnahmeposition eines Halteelements wird im Rahmen der vorliegenden Beschreibung derjenige Raumbereich verstanden, in welchem sich ein Halteelement befindet, wenn es bereit zur Aufnahme eines Bauelements von der Anordnung der Bauelementen ist bzw. wenn es gerade innerhalb des Vorgangs des Aufnehmens eines Bauelements aus der Anordnung von Bauelementen ist. Unter der Übergabeposition eines Halteelements wird derjenige Raumbereich verstanden, in welchem sich ein Halteelement befindet, wenn es bereit zur Übergabe eines Bauelements an den Bestückkopfs ist bzw. wenn es sich im Vorgang des Übergebens eines Bauelements an den Bestückkopfs befindet.

Unter dem optischen Strahlengang wird der räumliche Bereich verstanden, welchen ein von der Kamera erfasstes Bild auf dem Weg von der Quelle bis zum in der Kamera befindlichen Bildsensor überstreicht. Dies hat beispielsweise zur Folge, dass ein Fremdkörper, der sich im optischen Strahlengang befindet oder in diesen hineinragt zu Fehlern im Bild des aufgenommenen Objekts in der Kamera führt.

Ein Bild der Anordnung von Bauelementen im Bereich der Aufnahmeposition kann z.B. vorliegen, wenn das Bild diejenigen Bauelemente der Anordnung von Bauelementen umfasst, die in unmittelbarer Nachbarschaft zu einem Aufnahmebereich eines in der Aufnahmeposition befindlichen Halteelements liegen. Dieser Aufnahmebereich kann beispielsweise die Pipettenspitze bei einer Vakuumpipette oder die Greifeinheit bei einem mechanischen Greifer sein.

Der optische Strahlengang kann z.B. keine weiteren optischen Elemente umfassen, die zwischen dem aufzunehmenden Bereich der Anordnung von Bauelementen und dem Bildsensor der Kamera liegen. Weiterhin kann der optische Strahlengang reflektierende Elemente, wie beispielsweise Spiegel oder Prismen sowie optische Linsen umfassen. Weiterhin kann der Strahlengang optische Fasern, optische Faserbündel oder auch eine Endoskop-Optik umfassen. Weiterhin kann der optische Strahlengang beispielsweise zumindest teilweise in einem Hohlkörper geführt werden. Ein solcher Hohlkörper kann beispielsweise als Durchführung und/oder als länglicher Hohlkörper, wie beispielsweise eine eckige oder runde Röhre, ausgebildet sein.

Eine zur Aufnahme eines Bildes mit der Kamera verwendete Beleuchtung kann beispielsweise ebenfalls unter Verwendung von zumindest Teilen des optischen Strahlengangs erfolgen. Entsprechendes Beleuchtungs-Licht verläuft dann z.B. in zumindest Teilen des optischen Strahlengangs. Dabei können weiterhin z.B. zumindest Teile einer zugeordneten Beleuchtungseinrichtung (z.B. eine Leuchtdiode oder eine Anordnung von Leuchtdioden oder ähnlichen Lichtquellen) im optischen Strahlengang oder in unmittelbarer Nähe zum optischen Strahlengang angeordnet sein.

Unter dem Betrieb der Überführungseinrichtung ist im genannten Zusammenhang der regelmäßige Betrieb im Rahmen der Bestückung von Substraten mit Bauelementen durch den Bestückautomaten gemeint. Besondere Justage- und/oder Testprozeduren werden im Allgemeinen nicht als (regelmäßiger) Betrieb der Überführungseinrichtung betrachtet.

Dass der optische Strahlengang von Teilen der Überführungseinrichtung höchstens dann gekreuzt wird, wenn sich ein Halteelement im Bereich der Aufnahmeposition befindet, ist so zu verstehen, dass der optische Strahlengang entweder von Teilen der Überführungseinrichtung überhaupt nicht gekreuzt wird oder nur dann von Teilen der Überführungseinrichtung gekreuzt wird, wenn sich eine Halteelement im Bereich der Aufnahmeposition befindet. Der Bereich der Aufnahmeposition ist dabei nicht auf die exakte Aufnahmeposition beschränkt, sondern erstreckt sich über die Bereiche, die ein Halteelement vor und nach dem Erreichen der Aufnahmeposition überstreichen. Bei einer Drehbewegung des Halteelements kann dies beispielsweise der Winkelbereich von 60 Grad vor Erreichen der Aufnahmeposition bis 60 Grad nach Verlassen der Aufnahmeposition bedeuten. Bevorzugt kann der Bereich sich auch von einer Position, die 45 Grad vor Erreichen der Aufnahmeposition liegt, bis zu einer Position, die 45 Grad nach dem Verlassen der Aufnahmeposition liegt, erstrecken. Weiter bevorzugt kann dieser Winkelbereich auch zwischen 30 Grad vor der Aufnahmeposition bis zu 30 Grad nach Verlassen der Aufnahmeposition liegen.

Weiterhin kann der optische Strahlengang derart ausgebildet sein, dass außer Teilen der Überführungseinrichtung, wenn sich ein Halteelement im Bereich der Aufnahmeposition befindet, keine weiteren Teile der Zuführeinrichtung und des Bestückautomaten im Strahlengang liegen können.

Unter "im Strahlengang liegt" bzw. "Kreuzen des Strahlengangs" kann dabei verstanden werden, dass Teile teilweise oder auch vollständig im Strahlengang liegen. Weiterhin kann es bedeuten, dass der Strahlengang dabei nur teilweise oder auch vollständig unterbrochen wird.

Die Zuführeinrichtung kann weiterhin derart ausgestaltet sein, dass vermittels einer Drehung der Überführungseinrichtung, insbesondere um die Drehachse, ein Halteelement von der Aufnahme- in die Übergabeposition bewegbar ist. Vermittels einer solchen Ausgestaltung kann eine besonders Platz sparende und effiziente Übergabe eines Bauelements aus der Anordnung von Bauelementen an den Bestückkopf des Bestückautomaten erreicht werden.

Weiterhin kann die Zuführeinrichtung derart ausgestaltet sein, dass immer dann, wenn sich ein Halteelement in der Aufnahmeposition befindet gleichzeitig ein weiteres Halteelement der Überführungseinrichtung in der Übergabeposition ist. Diese Ausgestaltung hat den Vorteil, dass immer, wenn ein Halteelement in der Aufnahmeposition ist auch gleichzeitig ein Bauelement an den Bestückkopf übergebbar ist oder übergeben wird. So dass es möglich ist, die Zuführeinrichtung derart zu betreiben, dass die Aufnahme eines Bauelements und die Übergabe eines Bauelements an einen Bestückkopf immer gleichzeitig durchführbar sind, was den Übergabeprozess besonders effizient macht.

Der optische Strahlengang kann derart ausgebildet und angeordnet sein, dass Licht, welches von der Anordnung von Bauelementen im Bereich der Aufnahmeposition abgestrahlt wurde, im Bereich der Drehachse der Überführungseinrichtung aus einer Arbeitsebene austritt. Die Arbeitsebene ist dabei derjenige eben ausgedehnte räumlich Bereich, in welchem sich die Halteelemente der Überführungseinrichtung bei einer Drehung der Überführungseinrichtung bewegen. Unter dem "Bereich der Drehachse" wird dabei der Bereich der Arbeitsebene im näheren oder weiteren Umfeld der Drehachse verstanden. Insbesondere erstreckt sich der "Bereich der Drehachse" innerhalb der Fläche, die durch die Halteelemente bei der Drehung der Überführungseinrichtung begrenzt wird. Diese Ausgestaltung hat den Vorteil, dass der optische Strahlengang die Arbeitsebene und damit unter Umständen auch den Bereich drehender Teile im Bereich der Drehachse verlässt und so durch die sich drehende Überführungseinrichtung nicht mehr beeinträchtigt werden kann.

Die Zuführeinrichtung kann dabei derart ausgestaltet sein, dass der optische Strahlengang die Arbeitsebene auf einer Seite verlässt, auf welcher auch mechanische Elemente zur drehbaren Lagerung der Überführungseinrichtung angeordnet sind. Auf diese Weise lässt sich eine sehr kompakte Zuführeinrichtung konstruieren, bei welcher alle wesentlichen Teile der Zuführeinrichtung auf einer Seite der Arbeitsebene liegen und die andere Seite dann relativ frei zugänglich ausgestaltet werden kann.

Alternativ kann die Zuführeinrichtung auch so ausgestaltet sei, dass der optische Strahlengang die Arbeitsebene auf einer Seite verlässt, die der Seite gegenüber liegt, auf welcher die mechanische Elemente zur drehbaren Lagerung der Überführungseinrichtung angeordnet liegen. Dadurch, dass die mechanischen Elemente zur drehbaren Lagerung der Überführungseinrichtung und ein außerhalb der Arbeitsebene verlaufender Teil des optischen Strahlengangs auf verschiedenen Seiten der Arbeitsebene liegen, müssen diese Komponenten nicht so genau aufeinander abgestimmt sein. Sie lassen sich in diesem Fall also z.B. relativ unabhängig voneinander entwickeln und ausgestalten.

In einer weiteren Alternative kann der optische Strahlengang derart ausgestaltet sein, dass er vollständig innerhalb der Arbeitsebene verläuft, diese also nicht verlässt. Dies lässt sich beispielsweise erreichten, wenn die Kamera sich zumindest zu Teilen oder auch insgesamt ebenfalls in der Arbeitsebene befindet. Auf diese Weise kann beispielsweise weiterhin die Kamera mit der Überführungseinheit zu einer Baugruppe als Flipeinheit kombiniert werden. Hierbei können insbesondere auch Miniaturkameras verwendet werden.

Der optische Strahlengang kann weiterhin derart ausgestaltet sein, dass das von der Anordnung von Bauelementen abgestrahlte Licht nach dem Austritt aus der Arbeitsebene zumindest abschnittsweise im Wesentlichen parallel zur Drehachse läuft. Weiterhin kann der optische Strahlengang derart eingerichtet sein, dass er nach dem Austritt aus der Arbeitsebene dann insgesamt im Wesentlichen parallel zur Drehachse verläuft. Da eine drehbar gelagerte Überführungseinrichtung so ausgestaltet werden kann, dass sich im Bereich der Drehachse keine bewegten Teile befinden, lässt sich so der optische Strahlengang besonders geschickt bis zur Kamera führen.

Die Überführungseinrichtung kann in einer weiteren Ausgestaltung der Erfindung ein mechanisches Drehlager zur drehbaren Lagerung der Überführungseinrichtung um die Drehachse umfassen, wobei das mechanische Drehlager zumindest abschnittsweise als Hohlkörper, insbesondere auch vollständig als Hohlkörper ausgebildet sein kann und der optische Strahlengang zumindest zum Teil innerhalb dieses Hohlkörpers verlaufen kann. Der optische Strahlengang kann dann zum Beispiel entweder frei durch einen Innenbereich des Hohllagers verlaufen oder auch beispielsweise in einem zusätzlichen Hohlkörper, beispielsweise einem Rohr geführt werden. Der optische Strahlengang kann weiterhin auch durch einen oder durch den Hohlkörper verlaufenden Faserbündel oder einer entsprechend verlaufenden Endoskop-Optik geführt sein. Auf diese Weise lässt sich ein besonders einfacher Verlauf des optischen Strahlengangs realisieren, da im allgemeinen Fall innerhalb eines solchen Drehlagers keine beweglichen Teile der Überführungseinrichtung mehr liegen.

Da in vielen Fällen die Aufnahmeelemente der Bestückköpfe von Bestückautomaten der Anordnung von Bauelementen gegenüberliegend angeordnet sind, weist in einer vorteilhaften Ausgestaltung die Überführungseinrichtung eine gerade Anzahl von Halteelementen auf, die jeweils bezüglich der Drehachse der Überführungseinrichtung symmetrisch gegenüberliegend angeordnet sind. Damit haben die entsprechend symmetrisch angeordneten Halteelemente eine entgegen gesetzte Orientierung und sind somit der vorstehend genannten häufig vorzufindenden Grundorientierung von Bestückautomat und Zuführeinrichtung angepasst.

Die Überführungseinrichtung kann insbesondere zwei oder vier Halteelemente aufweisen, die jeweils bezüglich der Drehachse symmetrisch gegenüberliegend angeordnet sind. In einer besonders bevorzugten Ausbildung einer Überführungseinrichtung mit vier Halteelementen können diese regelmäßig angeordnet sein, so dass diese jeweils um einen Drehwinkel von 90° gegeneinander versetzt sind. Dabei gelten jeweils zwei Halteelemente als "symmetrisch gegenüber der Drehachse angeordnet", wenn die eine mittels einer Drehung um 180° in die Position der anderen bewegbar ist. Diese Ausgestaltung hat den Vorteil, dass sich auf diese Weise eine besonders einfache und regelmäßige Prozessführung erreichen lässt.

Die vorstehend genannte Aufgabe wird weiterhin gelöst von einem Bestücksystem mit einem Bestückautomaten zum Bestücken von Substraten von Bauelementen und einer Zuführeinheit gemäß der vorangehenden Beschreibung, wobei der Bestückautomat einen Bestückkopf umfasst und die Zuführeinheit zur Übergabe von Bauelementen an den Bestückkopf vorgesehen ist.

Die Kombination des Merkmals, dass der optische Strahlengang von Teilen der Überführungseinrichtung höchstens dann gekreuzt wird, wenn sich ein Halteelement im Bereich der Aufnahmeposition befindet und der Tatsache, dass die Überführungseinrichtung derart ausgebildet ist, dass gleichzeitig ein Bauelement aus der Anordnung von Bauelementen entnehmbar ist oder entnommen wird und ein anderes Bauelement and den Bestückkopf übergebbar ist oder übergeben wird, führt zu einer verbesserten Anpassung des Bestücksystems an mit dem Bestücksystem verwendbare oder verwendete Mehrfach-Bestückköpfe.

Insbesondere kann der Bestückkopf eine Mehrzahl von Aufnahmeelementen aufweisen. Der Bestückkopf kann beispielsweise weiterhin drehbar gelagert sein. Solche drehbar gelagerten Mehrfach-Bestückköpfe werden häufig auch als "Revolverköpfe" bezeichnet. Weiterhin kann der Mehrfach-Bestückkopf auch im Wesentlichen parallel angeordnete Aufnahmeelemente aufweisen. Solche Mehrfach-Bestückköpfe können als so genannte "Matrix-Köpfe" oder auch als drehbar gelagerte "Revolver-Köpfe" ausgebildet sein.

Weiterhin kann der Bestückautomat eine Positioniereinheit zum zweidimensionalen Positionieren des Bestückkopfs über einem Substrat und eine mit der Positioniereinheit verbundene Kamera zur Betrachtung von am Bestückkopf befindlichen Bauelementen umfassen. Auf diese Weise kann nach der Übernahme eines Bauelements durch den Bestückkopf des Bestückautomaten nachfolgend die Lage des Bauelements am Bestückkopf betrachtet werden. Da die Kamera in diesem Fall mit der Positioniereinheit verbunden ist, kann dies beispielsweise auch auf dem Transportweg von der Übergabeposition des Bauelements zu der Stelle, an welcher das Bauelement auf dem Substrat platziert wird, geschehen. Besonders vorteilhaft ist diese Ausgestaltung bei der Verwendung von Mehrfach-Bestückköpfen.

Ein besonderer Vorteil liegt vor, wenn mittels der Kamera eine Aufnahmeeinrichtung beobachtbar ist, die derzeit nicht in der Übernahmeposition steht, so dass gleichzeitig von einem Aufnahmeelement ein Bauelement von der Überführungseinrichtung übernommen werden kann und mit der genannten Kopfkamera ein bereits in einem vorherigen Schritt übergebenes Bauelement an einem anderen Bestückkopf-Aufnahmeelement betrachtet werden kann.

Diese Ausgestaltung verbessert den Verfahrensablauf weiterhin, da in diesem Fall gleichzeitig ein Bauelement von der Anordnung von Bauelementen abgenommen, ein weiteres Bauelement von der Überführungseinrichtung an ein Aufnahmeelement des Bestückkopfes übergeben werden und zum Dritten ein drittes Bauelement, welches sich bereits an einer weiteren Aufnahmeeinrichtung des Bestückkopfs befindet, mit einer Kamera betrachtet werden.

Die vorstehend genannte Aufgabe wird weiterhin gelöst von einem Verfahren zum Überführen von Bauelementen von einer im Wesentlichen ebenen Anordnung von Bauelementen zu einem Bestückkopf eines Bestückautomaten unter Verwendung einer Zuführeinrichtung gemäß der vorangehenden Beschreibung, wobei das Verfahren den sich wiederholenden Ablauf der im Folgenden genannten Phasen umfasst:
1. Eine Stopp-Phase umfassend eine Aufnahme eines Bauelements von der Anordnung von Bauelementen und eine Übergabe eines weiteren Bauelements an den Bestückkopf;
2. Einer der Stoppphase nachfolgenden Drehphase, wobei während der Drehphase die Überführungseinrichtung derart gedreht wird, dass nach der Drehphase wiederum eine Halteeinrichtung der Überführungseinrichtung in der Aufnahmeposition befindlich ist und wobei weiterhin während der Drehphase mittels der Kamera ein Bild der Anordnung von Bauelementen aufgenommen wird;
3. Einer Korrekturphase, innerhalb welcher eine Veränderung der Lage der Anordnung von Bauelementen relativ zur Abholposition ausführbar ist oder ausgeführt wird, wobei die Korrekturphase einer ihr nachfolgenden Stopp-phase und/oder der vorausgehenden Drehphase zeitlich überlagert sein kann.

Auch dieses Verfahren weist die vorstehend bereits genannten Vorteile bezüglich einer verbesserten Anpassung an Bestückautomaten, welche Mehrfach-Bestückköpfe umfassen oder umfassen können, auf.

Während die Stoppphase und die ihr nachfolgende Drehphase logisch voneinander getrennt sind, kann die Korrekturphase einer nachfolgenden Stopp-Phase bzw. einer vorausgehenden Drehphase überlagert sein. So kann beispielsweise die Drehung bereits beendet sein und trotzdem die Lage der Anordnung von Bauelementen noch verändert werden. Weiterhin kann die Veränderung der Lage der Bauelemente auch während der Drehung der Überführungseinrichtung erfolgen.

In einer vorteilhaften Ausgestaltung kann der Bestückkopf als Mehrfach-Bestückkopf mit einer Mehrzahl von Aufnehmern für zu bestückende Bauelemente ausgebildet sein, wobei weiterhin zwischen zwei aufeinander folgenden Stoppphasen ein noch kein Bauelement aufweisender Aufnehmer zur Aufnahme eines Bauelements von der Zuführeinheit bereit gestellt wird. Das bedeutet, dass während die Überführungseinrichtung das nächste Halteelement mit einem Bauelement in die Übergabeposition bringt, der Mehrfach-Bestückkopf einen noch unbelegten Aufnehmer so in Position bringt, dass er das in der Übergabeposition der Überführungseinrichtung bereit gestellte Bauelement übernehmen kann. Diese Ausgestaltung ermöglicht wiederum eine verbesserte Effizienz bei der Übertragung von Bauelementen von einer Anordnung von Bauelementen an einen Bestückkopf eines Bestückautomaten, da der Takt der Übergabe durch die relativ schnell vorzunehmenden Bewegungen der Überführungseinrichtung und des Mehrfach-Bestückkopfs gegeben sind.

Im Folgenden wird die Erfindung beispielhaft mit Bezug auf die folgenden Figuren näher erläutert. Es zeigen:
- Figur 1:: Beispiel einer Kamera-Flipkopf-Einheit in perspektivischer Ansicht;
- Figur 2:: Die in Figur 1 dargestellte Kamera-Flipkopf-Einheit in einer Ansicht von unten;
- Figur 3:: Beispiel einer Anordnung zur Übergabe von Bauelementen von einem Wafer an einen Bestückkopf unter Verwendung der in Figur 1 und 2 gezeigten Kamera-Flipkopf-Einheit;
- Figur 4:: Die in Figur 3 dargestellte Anordnung in einem weiteren Arbeitszustand;
- Figur 5:: Detailzeichnung mit schematisch eingetragenem Strahlengang betreffend die Lichtführung innerhalb der in den vorangegangenen Figuren dargestellten Anordnung;
- Figur 6:: Weitere Ausführungsform einer Kamera-Flipkopf-Einheit in einer Ansicht von unten.

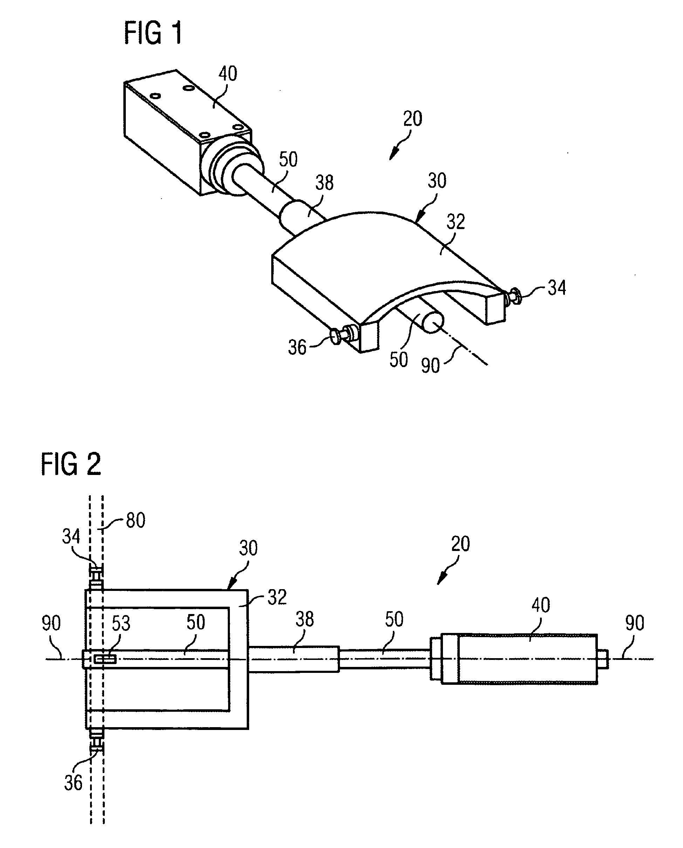

Figur 1 zeigt eine Kamera-Flipkopf-Einheit 20 zur Verwendung innerhalb eines Wafer Feeders zur Übertragung von Halbleiterchips von einem z.B. gesägten Halbleiter-Wafer zu einem Bestückkopf eines Bestückautomaten. Die Kamera-Flipkopf-Einheit 20 umfasst einen Flipkopf 30 mit einem Trägerelement 32, an welchem Vakuumpipetten 34, 36 zum Ansaugen, Festhalten und Transportieren von Bauelementen angebracht sind. Der Flipkopf 30 ist mittels einer Achshülse 38 um eine Drehachse 90 drehbar gelagert. Innerhalb der Achshülse und konzentrisch zu dieser verläuft ein längliches Hohlrohr 50, in welchem ein optischer Strahlengang teilweise geführt wird. Das Hohlrohr 50 ist mit einer Kamera 40 verbunden. In Hohlrohr 50 befindet sich im vorderen Bereich (bezüglich der Darstellung in Fig. 1) an der Unterseite eine Öffnung zum Lichteintritt, wobei das Licht dann von einer im Hohlrohr 50 befindlichen Abbildungsoptik zur Kamera 40 geführt wird.

Im in Figur 1 gezeigten Zustand der Kamera-Flipkopf-Einheit 20 ist diese Öffnung für einen Lichteintritt von unten (bzgl. Fig. 1) frei zugänglich, so dass mit der Kamera 40 ein Bild eines unter der Kamera-Flipkopf-Einheit 20 befindlichen Gegenstands, beispielsweise eines Halbleiter-Wafers, aufgenommen werden kann.

Figur 2 zeigt die in Figur 1 dargestellte Kamera-Flipkopf-Einheit in einer Ansicht von unten. Wiederum gezeigt ist der Flipkopf 30 mit dem Trägerelement 32 und den daran angebrachten Pipetten 34, 36, der mittels des Drehlagers 38 um die Drehachse 90 drehbar gelagert ist. Weiterhin ist wiederum das Strahlführungsrohr 50 und die daran anschließende Kamera 40 gezeigt. Das Strahlführungsrohr 50 weist eine Öffnung 53 auf, durch welche Licht in das Innere des Strahlführungsrohrs 50 gelangen kann und welches dann über eine im Strahlführungsrohr 50 befindliche Optik an die Kamera 40 weiter geleitet wird.

Während einer Drehung des Flipkopfes 30 bewegen sich die Pipetten 34, 36 in einer Arbeitsebene 80, die durch die Pipettenbewegung aufgespannt wird. Von unten kommendes Licht gelangt also im Bereich der Drehachse 90 in das Strahlführungsrohr 50 und wird dort ungefähr rechtwinklig umgelenkt und verlässt also im Bereich der Drehachse 90 die Arbeitsebene 80 im Wesentlichen rechtwinklig zur Arbeitsebene 80.

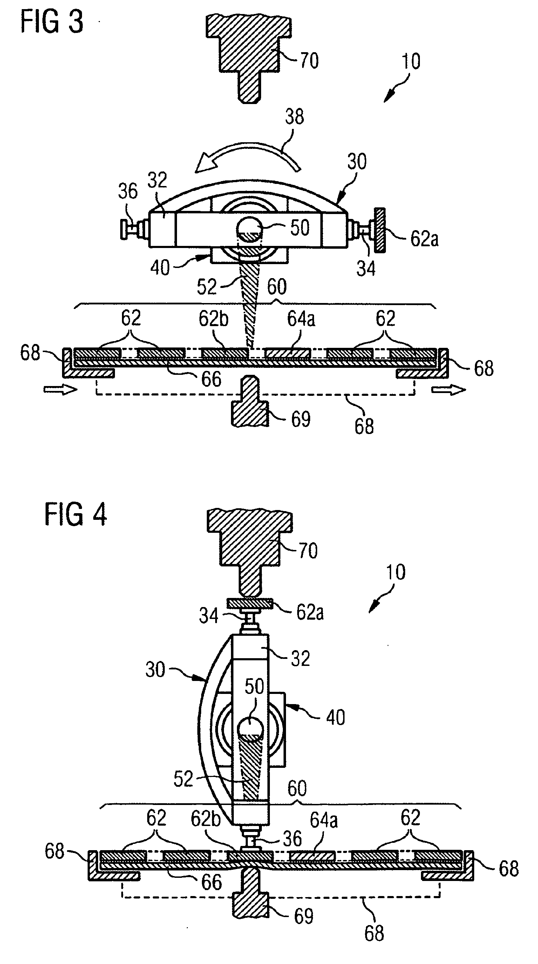

Figur 3 zeigt einen Ausschnitt eines Wafer-Feeders 10, der die in den Figuren 1 und 2 dargestellte Kamera-Flipkopf-Einheit umfasst. Dargestellt ist wiederum der Flipkopf 30 mit dem Trägerelement 32 und den Pipetten 34, 36 sowie das Strahlführungsrohr 50 und die Kamera 40 in einer Frontansicht. Weiterhin dargestellt ist ein Teil eines optischen Strahlengangs 52, der von einem Wafer 60 bis zur Strahlführungshülse 50 verläuft. Der Wafer 60 umfasst Bauelemente 62, 62b und eine Trägerfolie 66, auf welcher die Bauelemente 62, 62b gehalten werden.

Der Wafer 60 mit der Trägerfolie 66 wird von einem Halter 68 des Wafer Feeders fixiert und lässt sich durch eine Bewegung des Halters 68 verschieben. Weiterhin umfasst der Wafer Feeder 10 ein Ausstoßelement 69, mittels welchem ein Bauelement 62, 62b in Richtung zum Flipkopf 30 hin verschiebbar ist.

Im in Figur 3 dargestellten Zustand wurde bereits ein Bauelement 62a vom Wafer 60 entnommen, wo es eine Leerstelle 64a hinlassen hat. Der Flipkopf 30 hat sich dann nach der Aufnahme des Bauelements 62a durch die Pipette 34 in Pfeilrichtung 38 gedreht, um in den in Figur 3 dargestellten Zustand zu kommen.

Weiterhin dargestellt ist ein Bestückkopf 70 eines Bestückautomaten, an welchen das Bauelement 62a übergeben werden soll. Nach der Übernahme des Bauelements 62a fand bereits eine Verschiebung des Halters 68 mit dem Wafer 60 statt, um den in Figur 3 dargestellten Zustand zu erreichen. Im in Figur 3 dargestellten Zustand ist der optische Strahlengang 52 zur Aufnahme eines sich unter dem Strahlführungsrohr 50 befindenden Bereich des Wafers 60 unbeeinträchtigt, so dass ein Bild vom Wafer aufgenommen werden kann. Figur 3 stellt den Wafer Feeder in einer Drehphase gemäß der vorangehenden Beschreibung dar.

Figur 4 zeigt die in Figur 3 dargestellten Elemente nach einer weiteren Drehung des Flipkopfs 30 um 90 Grad. Im in Figur 4 dargestellten Zustand befindet sich die untere Pipette 36 in einem Aufnahmezustand zur Aufnahme des Bauelements 62b und die obere Pipette 34 befindet sich in einem Übergabezustand zur Übergabe des Bauelements 62a an den Bestückkopf 70. Die Aufnahme des Bauelements 62b durch die untere Pipette 36 erfolgt durch eine Aufwärtsbewegung des Ausstoßelements 69, der das Bauelement 62b gegen die untere Pipette 36 des Flipkopfs 30 drückt, gegebenenfalls kombiniert mit einer synchronen Aufwärtsbewegung der Pipette 36, wie in Abbildung 4 dargestellt. Während der Aufwärtsbewegung des Ausstoßelements 69 löst sich das Bauelement 62b von der Trägerfolie 66. Das Bauelement 62b ist in einem nachfolgenden Transportschritt, z.B. mittels einer Drehung des Flipkopfs 30 im Uhrzeigersinn (bezüglich der Darstellung in Figur 4) bewegbar.

Durch eine Absenkung des Bestückkopfs 70 lässt sich beispielsweise das an der oberen Pipette 34 befindliche Bauelement 62a fixieren und nach Unterbrechen des zur oberen Pipette 34 gehörenden Vakuumanschlusses vom Bestückkopf abnehmen.

In Figur 4 ist weiter zu erkennen, dass der außen liegende Teil des Strahlengangs 52, der in Abbildung 4 schraffiert dargestellt ist, durch ein Teil des Flipkopfs 30 unterbrochen wird, wenn die unter Pipette 36 in der Aufnahmeposition ist. Der blockierende Teil des Flipkopfs 30 ist dabei ein Teil des Trägerelements 32 sowie die untere Pipette 36.

Der in Figur 4 dargestellte Zustand des Wafer Feeders 10 entspricht einer möglichen Stoppphase gemäß der vorausgehenden Beschreibung.

Nachfolgend dem in Figur 4 gezeigten Zustand würde zum einen eine Transportphase des Wafers 60 zum Transport eines weiteren Bauelements 62 in eine Position, an welcher eine Pipette 34, 36 des Flipkopfs 30 dieses Abholen kann.

Zum Zweiten würde nach Übernahme des Bauelements 62b durch die untere Pipette 36 und Übergabe des an der oberen Pipette 34 befindlichen Bauelements 62a an den Bestückkopf 70 eine Drehung des Flipkopfs um 180° im Uhrzeigersinn stattfinden. Während der Drehung (einer Drehphase) kann wiederum ein Bild vom Wafer 60 bzw. eines Ausschnitts des Wafers 60 im Bereich der Abholposition von der Kamera 40 aufgenommen werden. Dies ist möglich, da während der Drehphase der Strahlengang 52 nicht unterbrochen und z.B. das nächste Bauteil zu diesem Zeitpunkt bereits im Strahlengang 52 positioniert sein kann. Ein Zwischenzustand innerhalb einer solchen Drehphase ist beispielsweise im Rahmen der Figur 3 erläutert.

Nach Beendigung dieser Drehphase befände sich nun die unbelegte, jetzt untere Pipette 34, in der Aufnahmeposition zur Aufnahme eines weiteren Bauelements 62, während die jetzt obere Pipette 36 gleichzeitig in der vorangegangenen Stopp-Phase aufgenommene Bauelement 62b an den Bestückkopf 70 übergeben kann. Der Wafer Feeder 10 befände sich dann wiederum in einer Stoppphase.

Nach Aufnahme eines Bauelements 62 durch die jetzt untere Pipette 34 und Übergabe des an der jetzt oberen Pipette 36 befindlichen Bauelements 62a an den Bestückkopf würde erneut eine Drehphase folgen, in welcher der Flipkopf dann gegen den Uhrzeigersinn wiederum um 180° gedreht würde, wobei während dieser Drehung wiederum ein Bild vom Wafer 60 durch die Kamera 40 aufgenommen werden könnte, da der optische Strahlengang 52 dann wieder ununterbrochen wäre.

Auf diese Weise ermöglicht der dargestellte Wafer Feeder 10 durch eine abwechselnde Hin- und Herdrehung des Flipkopfs 30 um jeweils 180 Grad eine sehr effiziente Übertragung von Bauelementen 62 an einen Bestückkopf 70. Dies ist besonders vorteilhaft, wenn der Bestückkopf 70 als Mehrfach-Bestückkopf ausgebildet ist, so dass während einer Drehung des Flipkopf 30 eine Bewegung des Bestückkopfs 70 derart erfolgt, dass ein neuer, bisher unbelegter Aufnehmer des Bestückkopfs dem Flipkopf zur Verfügung gestellt wird.

Durch die spezielle Ausgestaltung des Flipkopfs und die Lage und Anordnung des optischen Strahlengangs ist es möglich, ein Bild während der Drehbewegung aufzunehmen, so dass zur Aufnahme des Bilds der Übergabevorgang nicht unterbrochen werden muss. Weiterhin erfolgen sowohl die Übernahme eines neuen Bauelements durch den Flipkopf als auch die Übergabe eines Bauelements an den Bestückkopf zur gleichen Zeit oder im gleichen Zeitfenster, so dass dafür auch nur ein Zeitfenster reserviert werden muss. Die Kombination dieser Eigenschaft bewirkt einen besonderen Vorteil bei der Verwendung des dargestellten Wafer Feeders 10, insbesondere bei der Zufuhr von Bauelementen zu einem Mehrfach-Bestückkopf.

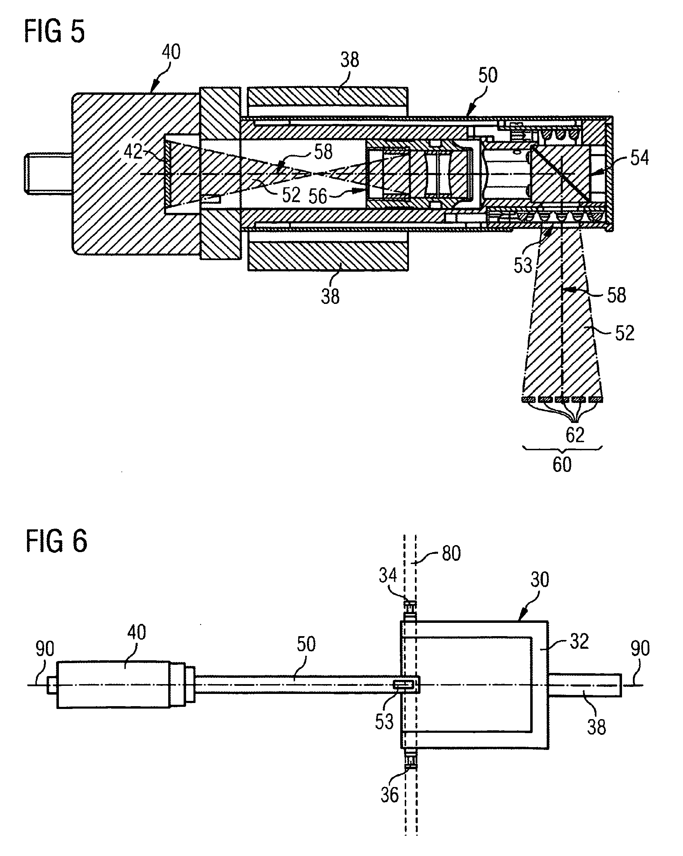

Figur 5 zeigt eine detailliertere Darstellung des optischen Strahlengangs, welcher allerdings aus Gründen der besseren Darstellbarkeit verzerrt dargestellt wurde und daher so nicht maßstabsgetreu ist. Insbesondere der Verlauf des optischen Strahlengangs 52 ist nur schematisch dargestellt. Dargestellt ist in Abbildung 5 wiederum die Kamera 40 mit einem CCD 42 als Bildaufnahmeelement. Der optische Strahlengang läuft, wie bereits in den Figuren 3 und 4 erläutert, in einem ersten Bereich senkrecht zum Wafer 60 im freien Raum und tritt dann in Strahlführungsrohr 50 ein. Innerhalb des Strahlführungsrohrs 50 wird es mittels eines Prismas 54 rechtwinklig umgelenkt und im Wesentlichen parallel zur Drehachse des Flipkopfs zum Bildaufnahmeelement 52 geführt. Die optische Abbildung erfolgt über ein Linsensystem 56, welches sich ebenfalls im Strahlführungsrohr 50 befindet. Auf diese Weise wird ein Bild eines Bereichs des Wafers 60 mit mehreren Bauelementen 62 auf dem CCD 42 der Kamera 40 erzeugt. Der Durchtritt des Strahlengangs 52 ins Innere des Strahlführungsrohrs 50 erfolgt über den Fensterbereich 53, der bereits ebenfalls in Figur 2 dargestellt ist.

In Figur 5 ist weiterhin die Drehhülse 38 des Flipkopfs dargestellt, welche für eine drehbare Lagerung des in Figur nicht vollständig dargestellten Flipkopfs sorgt.

In Figur 5 ist weiterhin eine optische Achse 58 eingezeichnet, welche im Inneren des Strahlführungsrohrs 50 nach Umlenkung durch das Prisma 54 im Wesentlichen parallel zur Drehachse des nicht in Figur 5 dargestellten Flipkopfs ist und mit dieser im Wesentlichen übereinstimmt.

Figur 6 zeigt eine alternative Ausführungsform zur in Figur 2 dargestellte Kamera-Flipkopf-Einheit in einer Ansicht von unten. Wiederum gezeigt ist der Flipkopf 30 mit dem Trägerelement 32 und den daran angebrachten Pipetten 34, 36, der mittels des Drehlagers 38 um die Drehachse 90 drehbar gelagert ist. Weiterhin ist wiederum das Strahlführungsrohr 50 und die daran anschließende Kamera 40 gezeigt. Das Strahlführungsrohr 50 weist eine Öffnung 53 auf, durch welche Licht in das Innere des Strahlführungsrohrs 50 gelangen kann und welches dann über eine im Strahlführungsrohr 50 befindliche Optik an die Kamera 40 weiter geleitet wird.

Während einer Drehung des Flipkopfes 30 bewegen sich die Pipetten 34, 36 in einer Arbeitsebene 80, die durch die Pipettenbewegung aufgespannt wird. Von unten kommendes Licht gelangt also im Bereich der Drehachse 90 in das Strahlführungsrohr 50 und wird dort ungefähr rechtwinklig umgelenkt und verlässt also im Bereich der Drehachse 90 die Arbeitsebene 80 im Wesentlichen rechtwinklig zur Arbeitsebene 80.

Im Unterschied zur in Figur 2 dargestellten Ausführungsform verläuft die Optik außerhalb der Arbeitsebene 80, also im Wesentlichen das Strahlführungsrohr 50 und die Kamera 50 auf einer dem Flipkopf 30 gegenüberliegenden Seite. Dies hat den Vorteil, dass beispielsweise Mechanik und Steuerung des Flipkopfs 30 nicht so genau auf die optischen Einrichtungen abgestimmt sein müssen. Daher können der Flipkopf 30 und die optische Einrichtung für diese Ausführungsform z.B. relativ unabhängig voneinander entwickelt und ausgestaltet werden.

Die vorliegende Erfindung beschreibt eine Zufuhreinheit zur Zufuhr von Bauelementen zu einem Bestückautomaten zum Bestücken von Substraten mit den Bauelementen, wobei die Zuführeinrichtung Bauelemente von einer im Wesentlichen ebenen Anordnung von Bauelementen entnimmt und an einen Bestückkopf des Bestückautomaten übergibt. Weiterhin umfasst die Zuführeinrichtung eine Kamera zur Aufnahme von zumindest Bereichen der Anordnung von Bauelementen, der ein optischer Strahlengang zur Aufnahme eines solchen Bilds zugeordnet ist.

Die Zuführeinrichtung ist dabei derart ausgebildet, dass gleichzeitig ein Bauelement von der Anordnung von Bauelementen von der Zuführeinrichtung aufgenommen werden kann und ein weiteres Bauelement an den Bestückkopf des Bestückautomaten abgegeben werden kann. Weiterhin ist die Zuführeinrichtung derart eingerichtet, dass der optische Strahlengang zur Aufnahme eines Bilds der Anordnung von Bauelementen mit der Kamera höchstens dann unterbrochen ist, wenn sich ein Aufnahmeelement der Zuführeinrichtung in einem Aufnahmezustand zur Aufnahme eines Bauelements von der Anordnung von Bauelementen befindet.

Auf diese Weise kann erreicht werden, dass mit einer verringerten Zahl von Arbeitsschritten und damit mit verbesserter Effizienz Bauelemente von einer im Wesentlichen Anordnung von Bauelementen einem Bestückkopf eines Bestückautomaten zugeführt werden können. Dabei weist die Zuführeinrichtung besondere Vorteile bei der Verwendung mit einem Bestückautomaten auf, welcher mindestens einen Mehrfach-Bestückkopf aufweist.

## Patentansprüche

1. Zuführeinrichtung zur Zufuhr von Bauelementen (62, 62a, 62b) zu einem Bestückautomaten zum Bestücken von Substraten mit den Bauelementen (62, 62a, 62b), umfassend:
- eine Halterung (68) für eine im wesentlichen ebene Anordnung von Bauelementen (60),
- eine um eine Drehachse (90) drehbar gelagerte Überführungseinrichtung (30) zur Überführung von Bauelementen (62, 62a, 62b) von der Anordnung von Bauelementen (60) zu einem Bestückkopf (70) des Bestückautomaten,
wobei die Überführungseinrichtung (30) mindestens zwei Halteelemente (34, 36) aufweist, die derart ausgebildet und angebracht sind, dass gleichzeitig 1.) ein in einer Aufnahmeposition befindliches erstes der Halteelemente (36) ein erstes Bauelement (62b) aus der Anordnung von Bauelementen (60) aufnehmen und 2.) ein in einer Übergabeposition befindliches zweites der Halteelemente (34) ein zweites Bauelement (62a) an den Bestückkopf (70) des Bestückautomaten übergeben kann, und
- eine Kamera (40) mit einem zugeordneten optischen Strahlengang (52) zur Aufnahme von Bildern der Anordnung von Bauelementen (60) im Bereich der Aufnahmeposition,
wobei sich die Halteelemente (34, 36) bei einer Drehung der Überführungseinrichtung (30) in einer Arbeitsebene (80) bewegen,
**dadurch gekennzeichnet,**
**dass** der optische Strahlengang (52) im Bereich der Drehachse (90) aus der Arbeitsebene (80) austritt und der optische Strahlengang (52) nach dem Austritt aus der Arbeitsebene (80) derart zumindest abschnittsweise im Wesentlichen parallel zur Drehachse (90) verläuft, und
**dass** bei einem Betrieb der Überführungseinrichtung (30) der optische Strahlengang (52) von Teilen der Überführungseinrichtung (30) höchstens dann gekreuzt wird, wenn sich ein Halteelement (34, 36) im Bereich der Aufnahmeposition befindet.

2. Zuführeinrichtung nach Anspruch 1,
**dadurch gekennzeichnet,**
**dass** vermittels einer Drehung der Überführungseinrichtung (30) ein Halteelement (34, 36) von der Aufnahme- in die Übergabeposition bewegbar ist.

3. Zuführeinrichtung nach Anspruch 1 oder 2,
**dadurch gekennzeichnet,**
**dass** immer, wenn sich ein Halteelement (34, 36) in der Aufnahmeposition befindet, gleichzeitig ein weiteres Halteelement (34, 36) der Überführungseinrichtung (30) in der Übergabeposition ist.

4. Zuführeinrichtung nach einem der Ansprüche 1 bis 3,
**dadurch gekennzeichnet,**
**dass** der optische Strahlengang (52) nach dem Austritt aus der Arbeitsebene (80) dann insgesamt parallel zur Drehachse (90) verläuft.

5. Zuführeinrichtung nach einem der Ansprüche 1 bis 4,
**dadurch gekennzeichnet,**
**dass** die Überführungseinrichtung (30) ein mechanisches Drehlager (38) zur drehbaren Lagerung der Überführungseinrichtung (30) umfasst, wobei das mechanische Drehlager (38) zumindest abschnittsweise als Hohlkörper ausgebildet ist und der optische Strahlengang (52) zumindest zum Teil innerhalb dieses Hohlkörpers verläuft.

6. Zuführeinrichtung nach einem der Ansprüche 1 bis 5,
**dadurch gekennzeichnet,**
**dass** die Überführungseinrichtung (30) eine gerade Anzahl von Halteelementen (34, 36) aufweist, insbesondere zwei oder vier Halteelemente (34, 36), die jeweils bezüglich der Drehachse (90) symmetrisch gegenüberliegend angeordnet sind.

7. Bestücksystem mit einem Bestückautomaten zum Bestücken von Substraten mit Bauelementen (62, 62a, 62b), wobei der Bestückautomat einen Bestückkopf (70) umfasst, und einer Zuführeinheit gemäß einem der Ansprüche 1 bis 6 zur Übergabe von Bauelementen (62, 62a, 62b) an den Bestückkopf (70).

8. Bestücksystem nach Anspruch 7,
**dadurch gekennzeichnet,**
**dass** der Bestückkopf (70) eine Mehrzahl von Aufnahmeelementen aufweist.

9. Bestücksystem nach Anspruch 8,
**dadurch gekennzeichnet,**
**dass** der Bestückkopf (70) drehbar gelagert ist und/oder dass die Aufnahmeelemente des Bestückkopfs (70) im Wesentlichen parallel angeordnet sind..

10. Bestücksystem nach einem der Ansprüche 7 bis 9,
**dadurch gekennzeichnet,**
**dass** der Bestückautomat eine Positioniereinheit zum zweidimensionalen Positionieren des Bestückkopfs (70) über einem Substrat und eine mit der Positioniereinheit verbundene Bestückkopf-Kamera zur Betrachtung von am Bestückkopf (70) befindlichen Bauelementen (62, 62a, 62b) umfasst.

11. Verfahren zum Überführen von Bauelementen (62, 62a, 62b) von einer im wesentlichen ebene Anordnung von Bauelementen (60) zu einem Bestückkopf (70) eines Bestückautomaten mit einer Zuführeinrichtung gemäß einem der Ansprüche 1 bis 6, umfassend die sich im Ablauf wiederholenden folgenden Phasen:
1.) einer Stopphase, umfassend eine Aufnahme eines Bauelements (62a) von der Anordnung von Bauelementen (60) und eine Übergabe eines weiteren Bauelements an den Bestückkopf (70);
2.) einer nachfolgenden Drehphase, wobei während der Drehphase die Überführungseinrichtung (30) derart gedreht wird, dass nach der Drehphase wiederum eine Halteeinrichtung (36) der Überführungseinrichtung (30) in der Aufnahmeposition befindlich ist und wobei weiterhin während der Drehphase mittels der Kamera (40) ein Bild der Anordnung von Bauelementen (60) aufgenommen wird;
3.) einer Korrekturphase, innerhalb welcher eine Veränderung der Lage der Anordnung von Bauelementen (60) relativ zur Abholposition ausführbar ist oder ausgeführt wird, wobei die Korrekturphase der nachfolgenden Stopphase und/oder der vorausgehenden Drehphase zeitlich überlagert sein kann.

12. Verfahren nach Anspruch 11,
**dadurch gekennzeichnet,**
**dass** der Bestückkopf (70) als Mehrfachbestückkopf mit einer Mehrzahl von Aufnehmern für zu bestückende Bauelemente (62, 62a, 62b) ausgebildet ist und
**dass** zwischen zwei aufeinander folgenden Stopphasen vom Mehrfachbestückkopf ein noch unbelegter Aufnehmer zur Aufnahme eines Bauelements (62, 62a, 62b) von der Zuführeinheit bereitgestellt wird.

## Claims

1. Feeder device for feeding components (62, 62a, 62b) to an automatic placement machine for the purpose of populating substrates with the components (62, 62a, 62b), said feeder device comprising:
- a holder (68) for providing a substantially level arrangement of components (60),
- a transfer device (30) rotatably mounted about an axis of rotation (90) for the purpose of transferring components (62, 62a, 62b) from the arrangement of components (60) to a placement head (70) of the automatic placement machine, wherein the transfer device (30) has at least two holding elements (34, 36) which are embodied and mounted in such a way that simultaneously 1.) a first of the holding elements (36) located in a pickup position can pick up a first component (62b) from the arrangement of components (60) and 2.) a second of the holding elements (34) located in a transfer position can pass a second component (62a) to the placement head (70) of the automatic placement machine,
and
- a camera (40) having an associated optical beam path (52) for recording images of the arrangement of components (60) in the region of the pickup position,
wherein during a rotation of the transfer device (30) the holding elements (34, 36) move in a working plane (80), **characterised in that**
the optical beam path (52) exits from the working plane (80) in the region of the axis of rotation (90) and after exiting from the working plane (80) the optical beam path (52) runs at least in sections substantially parallel to the axis of rotation, in such a wayand
that during operation of the transfer device (30) the optical beam path (52) is crossed by parts of the transfer device (30) at most when a holding element (34, 36) is located in the region of the pickup position.

2. Feeder device according to claim 1,
**characterised in that**
a holding element (34, 36) can be moved from the pickup to the transfer position by means of a rotation of the transfer device (30).

3. Feeder device according to claim 1 or 2,
**characterised in that**
whenever one holding element (34, 36) is located in the pickup position a further holding element (34, 36) of the transfer device (30) is simultaneously in the transfer position.

4. Feeder device according to one of claims 1 to 3,
**characterised in that**
after exiting from the working plane (80) the optical beam path (52) then runs generally parallel to the axis of rotation (90) .

5. Feeder device according to one of claims 1 to 4,
**characterised in that**
the transfer device (30) includes a mechanical pivot bearing (38) for rotatably mounting the transfer device (30), wherein the mechanical pivot bearing (38) is embodied at least in sections as a hollow body and the optical beam path (52) runs at least partly within said hollow body.

6. Feeder device according to one of claims 1 to 5,
**characterised in that**
the transfer device (30) has an even number of holding elements (34, 36), in particular two or four holding elements (34, 36), which are disposed symmetrically opposite one another in each case with respect to the axis of rotation (90) .

7. Placement system comprising an automatic placement machine for populating substrates with components (62, 62a, 62b), wherein the automatic placement machine includes a placement head (70), and a feeder unit according to one of claims 1 to 6 for passing components (62, 62a, 62b) to the placement head (70).

8. Placement system according to claim 7,
**characterised in that**
the placement head (70) has a plurality of pickup elements.

9. Placement system according to claim 8,
**characterised in that**
the placement head (70) is rotatably mounted and/or
**in that** the pickup elements of the placement head (70) are disposed in a substantially parallel arrangement.

10. Placement system according to one of claims 7 to 9,
**characterised in that**
the automatic placement machine includes a positioning unit for positioning the placement head (70) two-dimensionally over a substrate and a placement head camera connected to the positioning unit for the purpose of monitoring components (62, 62a, 62b) located at the placement head (70).

11. Method for transferring components (62, 62a, 62b) from a substantially level arrangement of components (60) to a placement head (70) of an automatic placement machine having a feeder device according to one of claims 1 to 6, comprising the following phases which are repeated in the course of the process workflow:
1.) a stop phase comprising a pickup of one component (62a) from the arrangement of components (60) and a transfer of another component to the placement head (70);
2.) a following rotation phase, wherein the transfer device (30) is rotated during the rotation phase in such a way that on completion of the rotation phase a holding device (36) of the transfer device (30) is once again located in the pickup position and wherein in addition an image of the arrangement of components (60) is recorded by means of the camera (40) during the rotation phase;
3.) a correction phase within which the position of the arrangement of components (60) relative to the pick position can be changed or is changed, wherein the correction phase can overlap in time with the following stop phase and/or the preceding rotation phase.

12. Method according to claim 11,
**characterised in that**
the placement head (70) is embodied as a multiple placement head having a plurality of pickers for components (62, 62a, 62b) requiring to be placed and
**in that** between two succeeding stop phases a still unassigned picker is prepared by the multiple placement head for receiving a component (62, 62a, 62b) from the feeder unit.

## Revendications

1. Dispositif d'alimentation pour l'introduction de composants (62, 62a, 62b) dans un automate d'implantation pour équiper des substrats de composants (62, 62a, 62b), comprenant :
- un support (68) pour un agencement essentiellement plan de composants (60),
- un dispositif de transfert (30) logé de manière rotative autour d'un axe de rotation (90) pour le transfert de composants (62, 62a, 62b) de l'agencement de composants (60) vers une tête d'équipement (70) de l'automate d'implantation, le dispositif de transfert (30) présentant au moins deux éléments de maintien (34, 36) qui sont réalisés et installés de manière à ce que, simultanément, 1) un premier des éléments de maintien (36) se trouvant dans une position de préhension puisse recevoir un premier composant (62b) à partir de l'agencement de composants (60) et 2) un deuxième des éléments de maintien (34) se trouvant dans une position de transfert puisse transmettre un deuxième composant (62a) à la tête d'équipement (70) de l'automate d'implantation, et
- une caméra (40) munie d'une trajectoire du rayon optique correspondante (52) pour la prise d'images du dispositif de composants (60) dans la zone de la position de préhension,
les éléments de maintien (34, 36), lors d'une rotation du dispositif de transfert (30), se déplaçant dans un plan de travail (80),
**caractérisé en ce**
**que** la trajectoire du rayon optique (52), dans la zone de l'axe de rotation (90), sort du plan de travail (80) et en ce que la trajectoire du rayon optique (52), après la sortie du plan de travail (80), s'étend au moins par sections essentiellement parallèlement à l'axe de rotation (90), et
en ce que lors d'un fonctionnement du dispositif de transfert (30), la trajectoire du rayon optique (52) est croisée par des parties du dispositif de transfert (30) tout au plus lorsqu'un élément de maintien (34, 36) se trouve dans la zone de la position de préhension.

2. Dispositif d'alimentation selon la revendication 1,
**caractérisé en ce**
**qu'**au moyen d'une rotation du dispositif de transfert (30), un élément de maintien (34, 36) est déplaçable de la position de préhension à la position de transfert.

3. Dispositif d'alimentation selon la revendication 1 ou 2,
**caractérisé en ce**
**qu'** à chaque fois qu'un élément de maintien (34, 36) se trouve dans la position de préhension, un autre élément de maintien (34, 36) du dispositif de transfert (30) est simultanément dans la position de transfert.

4. Dispositif d'alimentation selon l'une quelconque des revendications 1 à 3,
**caractérisé en ce**
**que** la trajectoire du rayon optique (52), après la sortie du plan de travail (80), s'étend alors en tout parallèlement à l'axe de rotation (90).

5. Dispositif d'alimentation selon l'une quelconque des revendications 1 à 4,
**caractérisé en ce**
**que** le dispositif de transfert (30) comprend un coussinet de pivotement mécanique (38) pour le logement rotatif du dispositif de transfert (30), le coussinet de pivotement mécanique (38) étant réalisé au moins par sections en tant que corps creux et la trajectoire du rayon optique (52) s'étendant au moins en partie à l'intérieur de ce corps creux.

6. Dispositif d'alimentation selon l'une quelconque des revendications 1 à 5,
**caractérisé en ce**
**que** le dispositif de transfert (30) présente un nombre pair d'éléments de maintien (34, 36), notamment deux ou quatre éléments de maintien (34, 36), qui sont respectivement disposés de manière symétriquement opposée par rapport à l'axe de rotation (90).

7. Système d'équipement muni d'un automate d'implantation pour équiper des substrats de composants (62, 62a, 62b), l'automate d'implantation comprenant une tête d'équipement (70), et d'une unité d'introduction selon l'une quelconque des revendications 1 à 6 pour le transfert de composants (62, 62a, 62b) à la tête d'équipement (70).

8. Système d'équipement selon la revendication 7,
**caractérisé en ce**
**que** la tête d'équipement (70) présente une pluralité d'éléments de préhension.

9. Système d'équipement selon la revendication 8,
**caractérisé en ce**
**que** la tête d'équipement (70) est logée de manière rotative et/ou en ce que les éléments de préhension de la tête d'équipement (70) sont disposés essentiellement parallèlement.

10. Système d'équipement selon l'une quelconque des revendications 7 à 9,
**caractérisé en ce**
**que** l'automate d'implantation comprend une unité de positionnement pour le positionnement bidimensionnel de la tête d'équipement (70) sur un substrat et une caméra de tête d'équipement raccordée à l'unité de positionnement pour observer les composants (62, 62a, 62b) se trouvant sur la tête d'équipement (70).

11. Procédé de transfert de composants (62, 62a, 62b) d'un agencement essentiellement plan de composants (60) vers une tête d'équipement (70) d'un automate d'implantation muni d'un dispositif d'alimentation selon l'une quelconque des revendications 1 à 6, comprenant les phases suivantes dont le déroulement est répétitif :
1) une phase d'arrêt, comprenant une préhension d'un composant (62a) de l'agencement de composants (60) et un transfert d'un autre composant à la tête d'équipement (70) ;
2) une phase suivante de rotation, le dispositif de transfert (30) étant tourné pendant la phase de rotation de manière à ce qu'après la phase de rotation un dispositif de maintien (36) du dispositif de transfert (30) soit à son tour dans la position de préhension et que, encore pendant la phase de rotation, une image de l'agencement de composants (60) soit prise au moyen de la caméra (40) ;
3) une phase de correction, pendant laquelle une modification de la position de l'agencement de composants (60) par rapport à la position de prélèvement est exécutable ou est exécutée, la phase de correction pouvant être superposée temporellement à la phase d'arrêt suivante et/ou à la phase de rotation précédente.

12. Procédé selon la revendication 11,
**caractérisé en ce**
**que** la tête d'équipement (70) est réalisée en tant que tête d'équipement multiple munie d'une pluralité de griffes pour les composants (62, 62a, 62b) à implanter et
en ce qu'entre deux phases d'arrêt successives, une griffe encore non occupée est préparée par la tête d'équipement multiple pour la préhension d'un composant (62, 62a, 62b) du dispositif d'alimentation.
